# EUROPEAN PATENT SPECIFICATION

(11) **EP 0 240 369 B1**
(45) Date of publication and mention of the grant of the patent: **15.09.1993**
(21) Application number: 87302953.2
(22) Date of filing: 03.04.1987
(51) Int. Cl.: C23C 14/34, C23C 14/36, H01J 37/34

(54) **Improved cathode and target design for a sputter coating apparatus**
Kathoden- und Target-Anordnung für eine Beschichtungsvorrichtung zum Zerstäuben
Conception technique d'une cathode et d'une cible pour un appareil de revêtement par pulvérisation

(30) Priority: 04.04.1986 US 848698
(43) Date of publication of application: 07.10.1987
(73) Proprietor: MATERIALS RESEARCH CORPORATION, Orangeburg New York 10962 (US)
(72) Inventor: Hurwitt, Steven D., Park Ridge New Jersey 07656 (US)
(74) Representative: Cross, Rupert Edward Blount

(56) References cited:
- EP-A- 0 127 272
- DE-A- 3 411 536
- DE-A- 3 442 206
- FR-A- 2 535 109
- GB-A- 2 161 837
- US-A- 4 486 287
- US-A- 4 572 776
- PATENT ABSTRACT OF JAPAN, unexamined applications, C field, vol. 10, no. 63, March 13, 1986 THE PATENT OFFICE JAPANESE GOVERNMENT PAGE 44C332
- PATENT ABSTRACTS OF JAPAN, unexamined applications, C field, vol.9, no. 166, july 11, 1985 THE PATENT OFFICE JAPANESE GOVERNMENT PAGE 128 C 290

## Description

This invention relates to the field of sputter coating, and more particularly, to the design of the cathode and target assembly for much apparatus.

Sputtering is an important technique for applying thin films to substrate materials, such as wafers utilized in manufacturing microelectronic components. The process can best be envisioned as a series of steps, occurring in a low-pressure chamber into which a gas, typically argon, has been introduced. A negative potential is applied to a cathode structure, establishing an electric field, and electrons from the cathode collide with argon atoms, creating ions and exciting a glow discharge. Accelerated by the cathode's negative potential, the ions travel parallel to the electric field lines and impact a target, composed of the coating material, carried in the cathode structure. The kinetic energy of these ions is sufficiently high to dislodge some target surface atoms, which then condense on the substrate to form the film.

One technique used in the sputtering art has been the employment of magnetic fields to enhance the ion bombardment of the target. In such apparatus, referred to as magnetron sputtering devices, magnetic means are disposed to induce a relatively strong field in the vicinity of the target face, with the magnetic field lines oriented generally perpendicular to those of the electric field. Electrons emitted from the target face are influenced by the magnetic field so that their path of motion becomes curved, and in effect, the magnetic field "traps" such electrons in the vicinity of the target. The effect of this action is to promote electron-argon collisions close to the target face, maximizing the ion flux bombarding the target. Typical of magnetron sputtering apparatus is the device disclosed in U.S. Patent No. 4,472,259, assigned to the assignee of the present invention.

From the perspective of the designer of sputtering apparatus, an important consequence of the ion bombardment is target heating. Ejection of a target material atom is only one result of an ion impacting the target surface, and the vast proportion of system input power appears finally as heat in the target. Thus, sputtering cathode systems are sensitive to design changes that call for increased input power, as increases in effective power (power that, for example, increases the deposition rate) entail increases in target heating.

Emerging design criteria specified by users of sputtering equipment call for power requirements that exceed the capacities of conventional apparatus. Several factors combine to produce this situation. First, users commonly specify relatively soft coating materials, such as gold, aluminum, or aluminum alloys. As discussed in more detail below, such materials present particular problems in dealing with target heating. Second, users call for higher deposition rates, to increase productivity and film quality. To achieve such rates requires equipment capable of operating at higher input power levels than are now seen in the art. And in addition, there exists a trend toward ever-larger substrates, requiring cathodes and targets larger than those heretofore produced, creating particular design problems.

These factors, and particularly the latter two, require equipment that departs from conventional designs in dealing with target heating. Yet the art has offered few innovations aimed at dealing with the problem of heat buildup. Moreover, as detailed below, conventional designs inherently limit the ability of a target to withstand the heat buildup of sustained high-power operation.

GB-A-2161837 (Balzers) discloses a sputtering target for a sputter coating apparatus, the sputtering target having an outer rim extending from a back face to a front face of said target.

GB-A-2161837 further discloses a sputtering target assembly for a sputter coating apparatus, the assembly comprising a sputtering target having an outer rim extending from a back face to a front face of target and a target holder having side walls defining a central cavity for receiving the target, a front face of said target holder providing a surface complementary to said back face of said target.

It is a broad object of the present invention to provide a sputtering target capable of sustained high-power operation.

A further object of the invention is the provision of a sputtering cathode assembly that effectively cools a target carried therein during high-power operation.

Another object of the invention is a sputtering target that employs controlled deformation to insure effective cooling and retention of sputtering face orientation.

A still further object of the invention is the provision of a sputtering cathode assembly that combines the functions of a magnetic pole piece, a target cooling means, and a mechanical stabilizer for the target.

According to a first aspect of the present invention there is provided a sputtering target for a sputter coating apparatus, the sputtering target having an outer rim extending from a back face to a front face of said target, characterised in that;
the back face of said target has an arch-like shape convex with respect to the target body
and said outer rim includes a plurality of ridges.

According to a second aspect of the present invention there is provided a sputtering target assembly for a sputter coating apparatus, the assembly comprising:
a sputtering target having an outer rim extending from a back face to a front face of said target and a target holder having side walls defining a central cavity for receiving the target, a front face of said target holder providing a surface complementary to said back face of said target characterised in that;
said side walls are positioned adjacent the target rim to form a restraining contact therewith when the target expands thereagainst, in use;
the target material between the front face of the target and the back face of the target has an arch-like shape arched into the cavity from the restraining side walls of the target holder;
and said side walls restrain, in use, heat-induced expansion of said target in a direction transverse to the axis of the assembly.

The above-identified and other objects are achieved in an example of the present invention, a cathode and target assembly, that includes a cathode body, a target nest, a sputtering target, and additional support structures. The cathode body may be formed of a strong ferromagnetic material formed for enclosing and stablizing the nest and target. Cathode body side walls include means for partially enclosing cooling passages, and the side wall also may serve as a magnetic pole piece.

A target nest, composed of heat-conductive material, is received within a well in the cathode body. The outer periphery of the nest and the central area of its back side include means for partially enclosing coolant passages, the former in registration with cathode body enclosing means, to form coolant channels at the interface between the nest and the body, and other channels in the next central area each of which is in fluid communication with coolant inlet and outlet means.

The additional support structures include magnet means, a cap, formed of rigid, nonferromagnetic material, and cooling means.

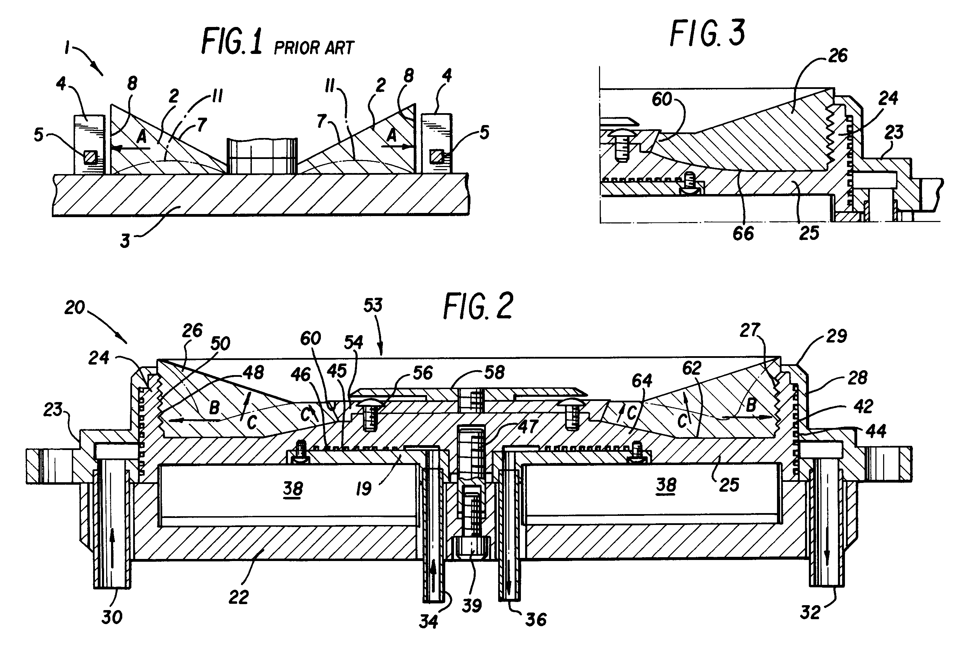

A target, composed of coating material, is similarly received within a central cavity in the face of the the nest. The inner periphery of the nest and the outer rim of the target carry cooling means, in the form of intermeshing projections and recesses. In a preferred embodiment, these means are in the form of a helical thread extending the vertical length of the nest inner periphery. The back face of the target and the front face of the nest form complementary surfaces, with the target back face having a convex, arch-like shape, formed as either a convex curved surface or as two surfaces whose intersection encloses an obtuse angle, the apex of which projects outward from the target back face. In one embodiment, one surface is planar, generally normal to the cathode assembly axis, and the other is conical. The target back face thus permits a controlled deformation of the target under expansive stresses imposed by heat buildup, such that the target will be urged into forceful, intimate contact with the cooled surfaces of the nest during operation.
FIGURE 1 depicts in schematic cross-section a typical sputtering cathode known in the art;
FIGURE 2 is a cross-sectional side view of an embodiment of the present invention;
FIGURE 3 is a detail cross-section of a portion of an alternative embodiment of the invention.
FIGURE 4 is a schematic cross-sectional representation of another alternative embodiment of the invention;
Understanding of the present invention will be enhanced by a consideration of the prior art and the limitations inherent in conventional design. The sputtering cathode shown in Fig. 1 is typical of apparatus known in the art. There, cathode assembly 1 includes a circular target 2, carried on a plate 3 and surrounded by a side wall 4. A coolant passage 5 formed in the side wall provides for heat transfer during operation. A central retainer 6 holds the target in position within the assembly.

A newly-installed target rests within the cathode body as depicted -- with the target bottom flat against the plate, and with some clearance (usually on the order of a few thousandths of an inch (1 inch = 25,4 mm)) between the target outer rim 8 and the interior of the side wall. During operation, the target temperature rises, creating expansive forces, as shown by arrows A. The target then expands, coming into contact with the cooled surface of the side wall. The plate 3 also offers a path for heat transfer, albeit a limited one, given the lack of forceful, intimate contact with a cooling surface.

For a relatively small cathode assembly, operated at relatively low power, the arrangement shown may provide sufficient cooling. It has been found, however, that this configuration proves deficient for larger, higher-power designs. In such a situation, especially when employing a target formed of relatively soft material, such as gold or aluminum, the cooling means of the prior art does not conduct away sufficient heat to prevent additional heat buildup within the target. Also, the size of the target becomes an important factor, as heat generated in the central portion of the target must travel to the target edge to be removed by the coolant.

Under such conditions, additional heat imposes additional expansive stresses; constrained at the outer periphery and the back face, and also constrained at the center by the retainer, the target expands in the direction of front face 7, buckling the target toward the shape shown by dotted line 11. Of course, as soon as the target buckles, the back face loses contact with plate 3, heat transfer through that path drops toward zero, and expansive forces against the cooled wall 4 are reduced (as the target outer rim displaces in response to the target distortion), exacerbating target heat buildup. In an extreme situation, the target temperature could exceed its melting point, leading to the loss of both the target and the material being coated, at substantial cost.

Moreover, the damage to the target is permanent. Given a relatively soft target material and high temperature, the target expansion takes the form of plastic, not elastic, flow. That is, the target does not return to its original shape but cools in the form it has assumed during operation. One would expect that subsequent operational cycles would only continue to extend the damage, and that expectatiom has been confirmed. Thus, it has been found that conventional designs do not permit operation at the cathode sizes and power requirements imposed by emerging design criteria.

Most important, these limitations are inherent in existing designs. Side wall cooling imposes clear limitations as target size increases, because heat at the center of the target cannot be extracted efficiently. Further, extant designs practically assure some degree of target distortion. If, as shown in Fig. 1, the target is constrained in three directions, it will respond as discussed above. If, as in some prior art designs, the center of the target is not restrained, the center will droop, progressively distorting the target shape on successive cycles. If the target is not restrained at the outer rim, that portion of the target will droop, similarly distorting the target shape. Whatever configuration the prior art employs, it cannot escape the consequences of the increased heat buildup imposed by larger target sizes and increased power requirements.

The present invention solves the problem of high power operation. Fig. 2 shows an embodiment of the invention, in which the cathode assembly 20 includes support structures, a cathode body 23, a cathode nest 24 and a target 26. The assembly as shown is generally cylindrical in form, adapted for the coating of circular substrates such as wafers used in the manufacture of microelectronic components. Those in the art will understand that other substrate forms will require alteration of the shape of the cathode assembly to provide an appropriate pattern of coating material atoms, and the present invention can be adapted readily to such circumstances.

The cathode assembly of the present invention can be positioned as desired within a sputtering chamber, with the target sputtering face oriented downward, upward, or horizontally. For the purpose of reference, the term,"front" will hereinafter refer to the direction of the ion flux (the direction generally from the cathode assembly to the substrate), and the term "back" to the opposite direction.

The support structures associated with the cathode assembly constitute several distinct elements. A cap 22 forms the extreme back of the assembly, and is formed of a rigid, non-magnetic material, such as a strong aluminum alloy. This element provides structural strength to the assembly without affecting the magnetic field described below. Magnet means 38 are carried in a suitable cavity in the cap, and in the embodiment shown is a relatively flat, annular permanent magnet as known in the art. A central coolant passage cover 19, formed as a relatively thin annular member of non-magnetic material, lies at the forward face of the magnet means, coaxial with the cap. Conduits 30 and 32, received into opposite sides of the cap circumference, form side coolant inlet and outlet means, respectively, and similar conduits 34 and 36, received into circularly opposing points toward the center of the cap, form center coolant inlet and outlet means, respectively. Operation of the coolant system is explained in more detail below.

The cathode body 23 is a generally hollow cylindrical structure affixed to the outer periphery of the cap's front face, with side walls 28 extending outward from the cap and defining a central well. The cathode body is made up of a strong, ferromagnetic material, such as stainless steel, and plays a part in the cathode magnetic field. As known in the art, proper shaping of the cathode field is critical to controlling the erosion of coating material from the target. The cathode body includes lips 29, extending over the nest to the vicinity of the target. As the cathode body is a ferromagnetic material, the cathode body acts as a pole piece, with the lips concentrating the magnetic field lines to insure the optimum relationship between the field and the target.

Target nest 24 is received into the central well of the cathode body, and takes the form of a relatively flat, hollow cylinder with a closed back 25 and side walls 27 defining a central cavity. The back face of the nest conforms to the cathode body and support structures, with portions in engagement with the cap, the magnet means, and the retaining plate. Lips 29 at the forward end of the cathode body side walls retain the nest in position within the well. To support the central portion of the nest during operation (at which time the back of the nest is subjected to atmospheric pressure and the front face is subjected to the low pressures within the sputtering chamber), screw 39, extending frontward from the back face of the cap, engages stud 47 in the nest to maintain the nest in position. Stud 47 may be composed of a ferromagnetic material to form a pole piece to cooperate with the cathode body and the magnet means in shaping the magnetic field.

The nest, the cathode body and several elements of the support structure cooperate to form an efficient cooling system. Preferably, the nest is formed of a highly heat-conductive material, such as copper, to assist in heat transfer. Also, the embodiment shown provides two coolant systems, instead of relying on a single cooling passage in the side wall, as taught by the prior art. First, a side wall coolant system is provided. Ribs 42 are formed in the outer periphery of the nest side wall, and when the nest side wall engages the inner side wall of the cathode body, the ribs and the cathode body side wall define passages 44 around the outer circumference of the nest, several such passages being in fluid communication with side coolant inlet 30 and outlet 32. Vertical slots (not shown) formed in the nest side wall connect the passages, permitting a flow of coolant around the periphery of the nest. A second coolant system serves the central portion of the nest. There, circular ribs 45 are formed in the central area of the nest back face, and, in engagement with the central coolant cover plate 19, central coolant passages 46 are defined. Several such passages are in fluid communication with central coolant inlet 34 and outlet 36, and slots (not shown) interconnect the passages to permit a flow of coolant at the center of the nest.

Those in the art will understand that the cooling means discussed above can be modified in various ways. For example, the dual cooling means disclosed could be combined into a single system serving both the side wall and the central area of the nest. Alternatively, a design could incorporate a sufficient thickness of heat-conductive material, such as copper, in the nest so that additional cooling means for the central portion of the nest were unnecessary. Thus, no matter what the means employed, a surface effective to provide significant cooling to the target will be a "cooling" surface as that term is used herein, whether or not that surface is directly "cooled".

Sputtering target 26 is received within the central cavity of the nest, and preferably is an annular disk having a central aperture 53. The front (sputtering) face of the target preferably forms a frusto-conical depression, but any target profile known in the art can be employed, as is most suitable for a particular cathode configuration. Retainer 54 fits into the target central aperture, attached to the nest by screws 56 or other suitable means, and this retainer forms a means for restraining heat-induced expansion of the sputtering target, as explained hereafter. -A retainer shroud 58, attached to the upper surface of the retainer and extending over the retainer screws, prevents accumulation of coating material on same, facilitating the removal of the target. It should be noticed that the contact surface to between the target and the retainer is sloped, so that the end of the retainer bearing against the nest has a smaller diameter than does the opposite (forward) end. This profile eases, the separation of the retainer from the target, inasmuch as the target inner rim tends to shrink inward, as explained below, and to press against the retainer.

The target outer rim and the nest inner wall incorporate additional cooling means, in the form of intermeshing projections and recesses. The general object of such means is to increase the surface area of contact between the nest and the target, to promote heat flow from the target to the nest. It is recognized that if the size and configuration of the projections and recesses is similar, as would be the case in a design selected to maximize the contact area, the terms "projection" and "recess" become arbitrary. Therefore, for reference purposes, those portions of this cooling means formed in the surface of the nest inner wall will be designated "projections", and those formed in the outer rim of the target "recesses", regardless of the actual dimensions of the particular elements chosen. It will be understood that designs wherein the elements formed in the target outer rim extend beyond the surface of same, and the elements formed in the nest inner wall extend into the surface of game; such designs fall within the terms employed herein.

Preferably, the target rim cooling means is a helical thread 50, complementarily formed in the target outer rim and the nest inner wall and extending the entire vertical length of the wall. This structure permits the target to be screwed into the nest, offering additional structural stability. To account for the expansion and contraction of the target during operation and cooling cycles, the thread should have sufficient depth to prevent the target outer rim from disengaging from the thread during cooling. It has been found that threads of a coarser pitch than about 20 threads per inch serve to retain the target in position. Such dimensions provide about 70-75% greater contact surface than does the conventional flat vertical side wall.

Those skilled in the art will appreciate that alternative configurations of this target/nest cooling means can be effective. For example, a rectangular cathode assembly could employ the present invention, using fins formed in the nest and received by conforming recesses in the target, or vice versa.

The back face of the sputtering target and the front face of the nest central cavity form complementary surfaces, convex with respect to the target. Preferably, the target back face includes two surfaces, as illustrated in Fig. 2: a planar surface 62, generally normal to the axis of the target, and a conical surface 64 sloping from the back of the target toward the front. These surfaces intersect to enclose an obtuse angle, the apex of which projects away from the target, back face. An alternative approach, shown in Fig. 3, would form the target back face as a curved surface 66, convex to the target. It will become clear that any combination of surfaces having an arch-like shape, convex to the target, will produce the advantages of the invention, so that within the criterion that the face be convex, those in the art can elect to form the back face as a combination of planar, conical, curved, or other suitable surfaces, as desired.

Advantages of the invention emerge from a consideration of the operation of a cathode assembly constructed according to the principles outlined herein. A new sputtering target fits loosely within the nest, with a clearance of several thousandths of an inch between the target outer rim and the nest inner side wall 48, as well as between the target inner rim and the retainer 54. Further, the target back face 62, 64 generally bears against the front face of the nest central well, but the contact is neither forceful nor intimate. When operation is commenced, the target temperature rises, and the target begins to expand. Initially, the outer rim of the target moves outward, and the inner rim also increases in diameter. After the outer rim makes contact with the nest side wall, however, the target inner rim reverses direction and contracts, and continued expansion results in the inner rim eventually making contact with the retainer along surface 60. Thus, the nest side wall constitutes a first point at which expansive motion transverse to the cathode assembly axis is restrained, and the retainer constitutes a second point at which expansive transverse motion is restrained.

At this point the target is being cooled primarily through the side walls, assisted by the nest/target cooling means 50. Also, some cooling exists at the inner rim/retainer contact surface 60. High power operation, however, continues to add heat to the target, giving rise to additional expansive forces as shown by arrows B in Fig. 2. Inasmuch as the target is restrained from moving in a direction transverse to the assembly axis (horizontally in Fig. 2), the target is placed in compression, generating stresses normal to the plane of the target, as shown by arrows C. In the prior art design, the planar form of the target back face resulted in the target's buckling, but the present invention's convex, arch-like design promotes controlled deformation, in the direction of the nest front face. Thus, the back face of the target undergoes a controlled plastic deformation toward a cooling surface, coming into intimate, forceful contact with same. Unlike the prior art, however, that surface is cooled by passages 46, and the forceful contact promotes heat transfer from the target to the coolant flowing in these passages. At the same time, the slope of surface 60 also urges the target back face into contact with the nest, further assisting the coolant process. It can be expected that the combination of controlled deformation, means for restraining transverse expansive motion and additional cooling surfaces adequately will cool targets up to 11 inches diameter, operating at power inputs up to 30 kW. These specifications compare very favorably with typical prior art devices, which generally are limited to diameters of 5-9 inches and power inputs of 5-12 kW.

It should be noted that the helical thread 50 provides an additional advantage during target cooling after operation. As described above, target heating results in an increase in the inner diameter of the target, followed, by a shrinking of that diameter. Post-operational cooling of the target, however, does not result in the outer rim returning to its original diameter; rather, a greater contraction occurs at the target outer rim's forward edge, resulting in a pattern of contractive forces that would tend to rotate the outer rim of the sputtering target inward, about a point in contact with the inner rim. Given conventional retaining means for the target edge, the target would droop at its periphery, that shape being accentuated over repeated cycles as the friction between the target outer rim and the nest prevented the target from expanding into contact with the nest front face. In the present invention, however, the helical thread holds the target in position between cycles, and the slopes of individual threads provide a ramping action as the target expands upon renewed operation, urging the target toward its original orientation and allowing the controlled deformation again to place the target into cooling contact with the nest.

An additional advantage of the present invention can be seen in comparing the targets of the prior art and the invention. The forward-sloping profile of the target back face permits a reduced volume for the target of the present invention, whether the design of Fig. 2 or Fig. 3 is considered. Given that targets generally are composed of very pure materials and often of precious metals, this savings in volume will be significant. Further, this reduction in material will not affect performance, as the central portion of the target generally is not eroded during sputtering, but is either discarded or recycled.

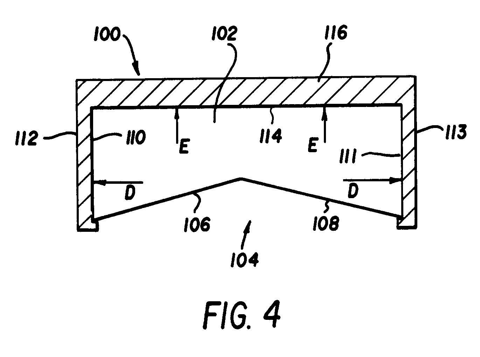

An alternative cathode assembly design 100 is schematically shown in Fig. 4. As seen, that assembly is generally formed in a rectangular configuration, with sputtering target 102 being also rectangular, having a front face 104 including two backwardly sloping portions 106, 108, defining an arch-like shape. Target sides 110, 111 are restrained from transverse expansive motion transverse to the target axis by two side walls 112, 113, and the relatively flat target back face 114 fits loosely against back wall 116. The side walls and and the back wall are cooled by appropriate means (not shown,), and the target sides/side wall interfaces can be provided with imtermeshing recesses and projections to provide additional cooling.

During operation, this embodiment expands sideways, as shown by arrows D until the target sides make contact with and are restrained by the respective side walls. Continued heat accumulation results in the target undergoing plastic deformation, the direction of which is preselected by the shaping of the target front face, toward the back wall, as shown by arrow E. The back face is thus placed in intimate, forceful contact with that wall, facilitating cooling therefrom. Thus, this cathode assembly responds to high heating levels in the same controlled manner as does the circular embodiment shown in Fig. 2.

As will be apparent to those in the art, various modifications and alterations can be made to the invention in adapting it to particular sputtering systems. For example, the shape of the target sputtering surface may be chosen from among a number of alternatives, based upon the cathode and magnet configurations. Similarly, the projection/recess cooling means in the target and nest can be implemented in a number of forms such as vertically disposed fins or the like. These and other modifications can be made within the scope of the invention, which is defined solely by the claims appended hereto.

## Claims

1. A sputtering target for a sputter coating apparatus, the sputtering target having an outer rim extending from a back face to a front face of said target, characterised in that;
the back face of said target has an arch-like shape convex with respect to the target body;
and said outer rim includes a plurality of ridges.

2. The sputtering target of Claim 1 wherein said sputtering target is disk-shaped and its back face includes a planar portion and a conical portion, said portions intersecting to enclose an obtuse angle whose apex projects away from the body of said target.

3. A sputtering target according to Claims 1 or 2 wherein said target is disk-shaped and said plurality of ridges are formed as helical threads.

4. A sputtering target assembly for a sputter coating apparatus, the assembly comprising:
a sputtering target having an outer rim extending from a back face to a front face of said target and a target holder having side walls defining a central cavity for receiving the target, a front face of said target holder providing a surface complementary to said back face of said target characterised in that;
said side walls are positioned adjacent the target rim to form a restraining contact therewith when the target expands thereagainst, in use;
the front face and/or the back face of the target have/has an arch-like shape arched into the cavity;
and said side walls restrain, in use, heat-induced expansion of said target in a direction transverse to the axis of the assembly.

5. An assembly according to Claim 4 wherein each of said outer rim of said target and the inner periphery of said side walls of said target holder have, respectively, a first and a second plurality of ridges which mutually intermesh.

6. An assembly according to Claims 4 or 5 wherein said back face of the target has an arch-like shape convex with respect to the target body.

7. An assembly according to Claim 5 wherein said sputtering target is disk-shaped and said pluralities of ridges are formed as helical threads.

8. An assembly according to Claims 6 or 7 wherein said sputtering target is disk-shaped and said back face includes a planar portion and a conical portion, said portions intersecting to enclose an obtuse angle whose apex projects away from the body of said target.

## Patentansprüche

1. Sputtertarget für einen Sputter-Beschichtungsapparat, mit einem Außenrand, der sich von einer hinteren Fläche zu einer vorderen Fläche des Targets erstreckt, **dadurch gekennzeichnet,** daß die hintere Fläche des Targets eine mit Bezug auf dessen Körper konvexe, bogenartige Form hat und der Außenrand eine Vielzahl von Rippen aufweist.

2. Sputtertarget nach Anspruch 1, **dadurch gekennzeichnet,** daß es scheibenförmig ist und seine hintere Fläche einen ebenen Bereich und einen konischen Bereich aufweist, wobei diese Bereiche an der Schnittstelle einen stumpfen Winkel einschließen, dessen Spitze vom Körper des Targets vorspringt.

3. Sputtertarget nach Anspruch 1 oder 2, **dadurch gekennzeichnet,** daß es scheibenförmig ist und die Vielzahl der Rippen schraubenförmige Gewindegänge bilden.

4. Sputtertarget-Anordnung für einen Sputter-Beschichtungsapparat, mit einem Sputtertarget mit einem Außenrand, der sich von einer hinteren zu einer vorderen Fläche des Targets erstreckt, und einem Targethalter, dessen Seitenwände einen zentralen Hohlraum zur Aufnahme des Targets begrenzen und dessen vordere Fläche eine zur hinteren Fläche des Targets komplementäre Fläche bildet, **dadurch gekennzeichnet,** daß die Seitenwände an dem Rand des Targets anliegen, um damit eine Rückhalteanlage zu bilden, wenn sich das Target bei Gebrauch dagegen ausdehnt, daß die vordere Fläche und/oder die hintere Fläche des Targets eine bogenartige, sich in den Hohlraum wölbende Form haben/hat, und daß die Seitenwände bei Gebrauch eine durch Erwärmung verursachte Ausdehnung des Targets in Richtung quer zur Achse der Anordnung begrenzen.

5. Anordnung nach Anspruch 4, **dadurch gekennzeichnet,** daß sowohl der Außenrand des Targets als auch die innere Umfangsfläche der Seitenwände des Targethalters jeweils eine Vielzahl von Rippen haben, die gegenseitig in Eingriff sind.

6. Anordnung nach Anspruch 4 oder 5, **dadurch gekennzeichnet,** daß die hintere Fläche des Targets eine bogenartige Form hat, die mit Bezug auf den Targetkörper konvex ist.

7. Anordnung nach Anspruch 5, **dadurch gekennzeichnet**, daß das Sputtertarget scheibenförmig ist und die jeweilige Vielzahl der Rippen schraubenförmige Gewindegänge bildet.

8. Anordnung nach Anspruch 6 oder 7, **dadurch gekennzeichnet**, daß das Sputtertarget scheibenförmig ist und die hintere Fläche einen ebenen Bereich und einen konischen Bereich aufweist, wobei diese Bereiche an der Schnittstelle einen stumpfen Winkel einschließen, dessen Spitze vom Körper des Targets vorspringt.

## Revendications

1. Cible de pulvérisation pour appareil de revêtement par pulvérisation, la cible de pulvérisation, possédant une bordure externe s étendant d'une face arrière à une face frontale de ladite cible, caractérisée en ce que
la face arrière de ladite cible possède une forme arguée, convexe par rapport au corps de la cible,
et la bordure externe comprend plusieurs nervures.

2. Cible de pulvérisation selon la revendication 1, dans laquelle la cible de pulvérisation est en forme de disque et sa face arrière comprend une partie plane et une partie conique, lesdites parties s'intersectant pour définir un angle interne obtus dont le sommet est en saillie par rapport au corps de ladite cible.

3. Cible de pulvérisation selon la revendication 1 ou 2, dans laquelle la cible est en forme de disque et les nervures sont formées sous la forme de filets hélicoïdaux.

4. Système de cible de pulvérisation pour un appareil de revêtement par pulvérisation, le système comprenant:
une cible de pulvérisation possédant une bordure externe s'étendant d'une face arrière à une face frontale de ladite cible et un porte-cible possédant des parois latérales définissant une cavité centrale pour recevoir la cible, une face frontale du porte-cible fournissant une surface complémentaire à la face arrière de ladite cible, caractérisé en ce que
lesdites parois latérales sont disposées près de la bordure de la cible pour former avec elle un contact de maintien lorsque la cible se dilate contre elles, en utilisation;
la face frontale et/ou la face arrière de la cible ont une forme arquée, courbée vers la cavité;
et lesdites parois limitent, en utilisation, la dilatation de la cible induite par la chaleur, dans une direction perpendiculaire à l'axe du système.

5. Système selon la revendication 4, dans lequel la bordure externe de ladite cible et la périphérie interne desdites parois latérales dudit porte-cible possèdent respectivement une première et une seconde pluralité de nervures qui s'interpénètrent.

6. Système selon la revendication 4 ou 5, dans lequel la face arrière de la cible a une forme arquée convexe par rapport au corps de la cible.

7. Système selon la revendication 5, dans lequel la cible de pulvérisation est en forme de disque et les nervures sont formées sous la forme de filets hélicoïdaux.

8. Système selon la revendication 6 ou 7, dans lequel la cible de pulvérisation est en forme de disque et la face arrière comprend une partie plane et une partie conique, ces parties s'intersectant pour former un angle obtus dont le sommet est en saillie, par rapport au corps de ladite cible.
